Europäisches Patentamt

European Patent Office

Office européen des brevets

Veröffentlichungsnummer: **0 284 757**

**A1**

# EUROPÄISCHE PATENTANMELDUNG

Anmeldenummer: **88102312.1**

Int. Cl.⁴ **H05K 3/22**

Anmeldetag: **17.02.88**

Priorität: 23.03.87 DE 3709452

Veröffentlichungstag der Anmeldung:
05.10.88 Patentblatt 88/40

Benannte Vertragsstaaten:
**AT BE CH DE FR GB IT LI NL SE**

Anmelder: **Siemens Aktiengesellschaft Berlin
und München
Wittelsbacherplatz 2
D-8000 München 2(DE)**

Erfinder: **Schneider, Bernd, Ing.grad.
Harthauser Strasse 79
D-8000 München 90(DE)**
Erfinder: **Zimmermann, Ulrich, Dipl.-Ing.
Gabelsbergerstrasse 67
D-8000 München 2(DE)**

**Leiterplatte.**

Die an Leiterplatten anfallenden Korrekturen, Reparaturen oder Nachrüstungen, die vor oder nach der Bestückung mit Bauteilen anfallen, werden mit Korrektur-und/oder Reparaturdrähten (3) durchgeführt. Die Korrektur-und/oder Reparaturdrähte (3), die zwischen zwei Anschlußflekken von Bauteilen verlegt werden, werden in rasterartig mit Noppen (1) versehenen Feldern mit sich kreuzenden Verlegebahnen (2) geführt. Derartige Felder können direkt auf die Leiterplatte oder mittels eines separaten Trägers (4), der auf der Leiterplatte plaziert wird, dargestellt werden.

FIG 2

EP 0 284 757 A1

## Leiterplatte

Die Erfindung betrifft eine Leiterplatte.

An Leiterplatten sind durch Fehler bei der Herstellung oder bei der Bestückung mit Bauteilen, sowie bei Weiterentwicklungen und bei Nachrüstungen fast immer Reparaturen notwendig. Hierzu stehen auf den Oberflächen der Leiterplatten zwischen den Bauelementen nur schmale Gassen zum Verlegen der Drähte zur Verfügung. Dies führt zu einer hohen Verlegedichte, da meist mehrere Korrekturen an einer Leiterplatte durchgeführt werden. Derartige nachträgliche Korrekturen oder Reparaturen werden durch Verlegen von lackisolierten Drähten bewerkstelligt, die an dafür vorgesehenen Anschlußflecken der Bauteile, sogenannten Pads, angelötet werden. Diese Drähte werden von Hand oder automatisch von einem Pad zum andern verlegt und beiderseits verlötet. Dies ist nicht nur in einer Ebene auf einer Leiterplatte sondern auch in mehrlagigen Leiterplatten zwischen verschiedenen Ebenen möglich.

Dem Stand der Technik entsprechende Leiterplatten werden mittels eines Verfahrens zum Aufbringen der Drähte auf die Leiterplatten korrigiert oder repariert wobei die lackisolierten Drähte zusätzlich mit einem Schmelzklebstoff beschichtet sind und durch eine Verlegekanüle geführt werden. Beginnend an einem Pad, an dem das Ende eines Drahtes angelötet ist, wird die Spitze der Kanüle, aus der dieser Draht nachgeführt wird, zum nächsten Pad bewegt, der Draht dort angelötet und anschließend abgeschnitten. Die Kanüle ist in diesem Fall beheizt und der vom Schmelzkleber umhüllte Draht wird durchgehend auf der Oberfläche der Leiterplatte angeklebt. Der für die Drahtverlegung vorgesehene Teil der Leiterplattenoberfläche ist mit metallischen Potentialbahnen versehen, damit der vorgeschriebene Wellenwiderstandswert eingehalten werden kann.

Die Haftfestigkeit der Drähte auf der Oberfläche der Leiterplatten ist beim Verlegen um scharfe Ecken, auf verschmutzten Oberflächen und bei hohen Temperaturen, z.B. mehr als 70° C, teilweise unzureichend. Die maximale Verlegedichte ist schnell erreicht, wenn U-oder Z-förmige Strukturen verlegt werden, da der Abstand zwischen verschiedenen Drähten an Ecken oder an Drahtkreuzungen wegen der beim Verlegen dieser Strukturen entstehenden mechanischen Spannungen ein Mindestmaß nicht unterschreiten darf. Andernfalls besteht die Gefahr der Ablösung der Drähte von der Leiterplatte. Parallel verlegte Drähte müsssen ebenfalls einen Mindestabstand zueinander haben, damit es nicht zum sogenannten Übersprechen kommt.

Der Erfindung liegt die Aufgabe zugrunde, die Oberfläche einer Leiterplatte so zu gestalten, daß die Verlegung von Korrektur-und/oder Reparaturdrähten möglichst einfach mit vorgegebenen Mindestabständen zwischen den Drähten und an ein oder mehrlagigen Leiterplatten durchgeführt werden kann.

Diese Aufgabe wird erfindungsgemäß dadurch gelöst, daß mindestens ein auf die Oberfläche der Leiterplatte aufgebrachtes, rasterartig mit Noppen versehenes Feld mit sich kreuzenden Verlegebahnen für Korrektur-und oder Reparaturdrähte vorhanden ist.

Auf dem Teil der Leiterplattenoberfläche, auf dem Drähte verlegt werden, wird das rasterartige Noppenfeld plaziert. Die Drähte werden zwischen zwei zu verbindenden Pads über dieses Noppenfeld geführt, wobei in den sich kreuzenden Verlegebahnen alle erforderlichen Verlegestrukturen für Drähte möglich sind. Die Mindestabstände zwischen den Drähten sind durch die Breite der Noppen automatisch vorgegeben.

Eine besondere Ausgestaltung der Erfindung sieht vor, daß zumindest ein Bereich des Feldes aus Metall besteht oder mit einer Metallauflage versehen ist. Dadurch können bestimmte geforderte Wellenwiderstandswerte für bestimmte Drähte eingehalten werden, die auf diesem entsprechend vorbereiteten Bereich verlegt sind. Der an Nullpotential liegende metallische Bereich des Feldes ist durch ein galvanoplastisches Verfahren einfach herstellbar.

In einer besonderen Ausgestaltung der Erfindung ist die Höhe der rasterartig angeordneten Noppen so bemessen, daß mehr als eine Lage von Drähten auf den Verlegebahnen zwischen den Noppen verlegbar ist.

Eine weitere vorteilhafte Ausgestaltung der Erfindung sieht vor, daß das rasterartige Noppenfeld auf einem eigenen plattenförmigen Träger aufgebracht ist, der wiederum auf dem dafür vorgesehenen Bereich auf der Leiterplatte plazierbar ist. Dieser plattenförmige Träger kann als Einzelstück auf die Leiterplatte aufgebracht werden oder, was die Verlegekapazität erweitert, in mehreren Lagen übereinander, wodurch wiederum die Drähte mehrlagig verlegt werden können.

Zur Positionierung der Träger mit dem darauf befindlichen Noppenfeld hat es sich als vorteilhaft erwiesen, mindestens eine Noppe als Positionier- oder Fixierstift auszugestalten. Diese Noppe ist höher ausgebildet als die restlichen und greift in eine entsprechende Vertiefung des darüberliegenden Trägers.

Besondere Ausgestaltungen der Erfindung beziehen sich auf den Querschnitt der Noppen und

ceren gegenseitige Anordnung. Hierbei ist es besonders vorteilhaft. wenn die Noppen einen quadratischen Querschnitt mit abgerundeten Kanten aufweisen. Unabhängig davon erweist es sich als günstig. wenn innerhalb der Rasterstruktur sich die Verlegebahnen rechtwinklig kreuzen.

Die folgenden Ausführungsbeispiele zeigen im einzelnen:

Fig. 1 einen plattenförmigen Träger mit quadratischen Noppen und rechtwinklig kreuzenden Verlegebahnen,

Fig. 2 eine Leiterplatte, mit Bauteilen, Pads ·Anschlußflecken), plattenförmigen Trägern mit quadratischen Noppen. senkrecht kreuzenden Verlegebahnen und Korrektur-und/oder Reparaturdrähten.

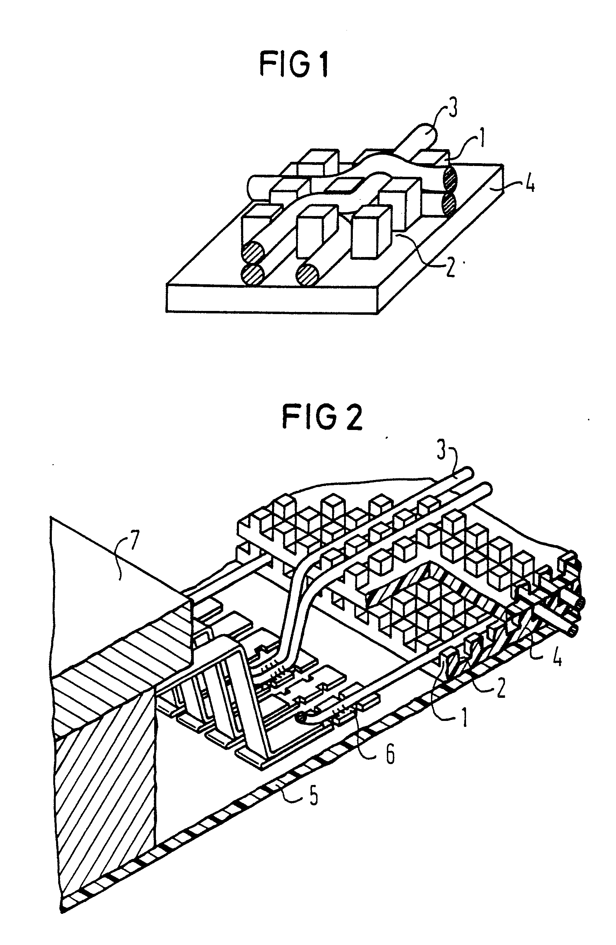

Fig. 1 zeigt einen plattenförmigen Träger 4, der auf die Oberfläche einer Leiterplatte aufgebracht, insbesondere aufgeklebt, wird. Auf diesem Träger 4 befinden sich Noppen 1 mit quadratischem Querschnitt. deren Höhe das ca. zwei-bis dreifache der dazwischen verlegten Drähte 3 beträgt. Die Verlegebahnen 2 kreuzen sich hier senkrecht und nehmen mehrere Drähte übereinander auf. Eine derartige Anordnung der Noppen ermöglicht es U-und Z-förmige Drahtbahnen, sowie durchgehende Drahtführungen einfach, ohne den Einsatz von Klebstoffen, ohne Niederhalter und ohne eine beheizbare Kanüle zum Verlegen der Drähte, auszuführen. Durch die Positionierung der Drähte 3 zwischen den Noppen 1 in den Verlegebahnen 2 wird automatisch ein Mindestabstand zwischen entsprechenden Drähten eingehalten, damit die Gefahr des Übersprechens ausgeschaltet ist. Der plattenförmige Träger 4 kann selbst metallisch sein oder auf seiner Oberfläche mit einer Metallauflage versehen sein, wobei das Metall an Nullpotential liegt und somit ein bestimmter Wellenwiderstandswert in den daraufliegenden Drähten eingestellt wird.

In Fig. 2 wird eine Leiterplatte 5 gezeigt, auf der sich elektronische Bauteile 7 befinden, die mit Anschlußflecken, sogenannten Pads 6, versehen sind. Die Korrektur-und/oder Reparaturdrähte 3 sind an diesen Pads angelötet und werden über die auf der Oberfläche der Leiterplatte 5 angebrachten plattenförmigen Träger 4 in den Verlegebahnen 2 zwischen den Noppen 1 geführt. Die Träger 4 sind in diesem Beispiel zweilagig vorhanden, so daß auch entsprechend zwei Lagen von Drähten 3 verlegt werden können. Die Höhe der Noppen 1 ist hier annähernd so ausgebildet, daß zwei Lagen von Drähten 3 in einem plattenförmigen Träger 4 übereinander verlegt werden können. Die Breite der Verlegebahnen 2 ist so dimensioniert, daß mindestens zwei Drähte darin nebeneinander Platz finden. Um das aufeinander stapeln der plattenförmigen Träger 4 nicht zu behindern. ist die Höhe der Noppen etwas größer. als der doppelte Durchmesser der lackisolierten Drähte 3. der bei ca 60 μm liegt.

Durch die beschriebene Ausführung der Erfindung wird ein besonders einfaches Verlegen von dünnen Korrektur-und/oder Reparaturdrähten auf Leiterplatten in mehreren übereinanderliegenden Ebenen ermöglicht. Dabei wird sichergestellt, daß für bestimmte Drähte vorgeschriebene Wellenwiderstandswerte eingehalten werden und für alle Drähte die Mindestabstände zu benachbarten Drähten gewährleistet sind.

**Ansprüche**

1. Leiterplatte,
**gekennzeichnet durch**
mindestens ein auf die Oberfläche aufgebrachtes, rasterartig mit Noppen (1) versehenes Feld mit sich kreuzenden Verlegebahnen (2) für Korrektur-und/oder Reparaturdrähte (3).

2. Leiterplatte nach Anspruch 1,
**dadurch gekennzeichnet,**
daß das Feld zumindest bereichsweise aus an Null-Potential liegendem Metall besteht.

3. Leiterplatte nach Anspruch 1,
**dadurch gekennzeichnet,**
daß das Feld zumindest bereichsweise mit einer an Null-Potential liegenden Metallauflage versehen ist.

4. Leiterplatte nach einem der vorhergehenden Ansprüche,
**gekennzeichnet durch**
daß das Feld galvanoplastisch aufgebracht ist.

5. Leiterplatte nach einem der vorhergehenden Ansprüche,
**dadurch gekennzeichnet,**
daß die Höhe der Noppen (1) derart bemessen ist, daß Korrektur-und/oder Reparaturdrähte (2) in mindestens zwei Lagen verlegbar sind.

6. Leiterplatte nach einem der vorhergehenden Ansprüche,
**dadurch gekennzeichnet,**
daß das rasterartig mit Noppen (1) versehene Feld auf einem plattenförmigen Träger (4) aufgebracht ist.

7. Leiterplatte nach Anspruch 5,
**dadurch gekennzeichnet,**
daß plattenförmige Träger (4) in mindestens zwei Lagen auf die Oberfläche der Leiterplatte (5) aufbringbar sind.

8. Leiterplatte nach Anspruch 6,
**dadurch gekennzeichnet,**
daß mindestens eine Noppe (1) als Positionier-und/oder Fixierstift ausgebildet ist.

9. Leiterplatte nach einem der vorhergehenden Ansprüche,

**dadurch gekennzeichnet,**

daß die Noppen (1) einen quadratischen Querschnitt mit abgerundeten Kanten aufweisen.

10. Leiterplatte nach einem der vorhergehenden Ansprüche,

**dadurch gekennzeichnet,**

daß die Verlegebahnen (2) sich rechtwinklig kreuzen.

# FIG 1

# FIG 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | FR-A-2 089 627 (THE BUNKER-RAMO CORP.) --- | | H 05 K 3/22 |
| A | FR-A-2 507 853 (BREFDENT) --- | | |
| A | DE-C- 652 197 (R.C.A.) ----- | | |

RECHERCHIERTE SACHGEBIETE (Int. Cl.4)

H 05 K

Der vorliegende Recherchenbericht wurde für alle Patentansprüche erstellt

| Recherchenort | Abschlußdatum der Recherche | Prüfer |
|---|---|---|
| DEN HAAG | 01-07-1988 | SCHUERMANS N.F.G. |